# DEMANDE DE BREVET EUROPEEN

(11) **EP 2 645 436 A1**
(43) Date de publication de la demande: **02.10.2013**
(21) Numéro de dépôt: 13160861.4
(22) Date de dépôt: 25.03.2013
(51) Int. Cl.: H01L 33/64, H01L 33/62

(54) **Composant LED a faible résistance thermique avec chemins électrique et thermique dissocies**

(30) Priorité: 28.03.2012 FR 1252795
(71) Demandeur: Commissariat à l'Énergie Atomique et aux Énergies Alternatives, 75015 Paris (FR)
(72) Inventeur: Gasse, Adrien, 38180 Seyssins (FR); Levy, François, 38640 CLAIX (FR)
(74) Mandataire: Ilgart, Jean-Christophe

(57) **Abrégé**

La présente demande concerne un composant émetteur de rayonnement lumineux comprenant : une jonction verticale (102-104) reposant sur un substrat doté sur une face opposée à celle sur laquelle est réalisée la jonction d'au moins une première zone conductrice (112) dédiée à une prise de contact électrique et d'une deuxième zone conductrice (114), isolée du substrat et de la première zone conductrice, la deuxième zone étant dédiée à une dissipation thermique.

## Description

### DOMAINE TECHNIQUE

Le domaine de l'invention se rapporte à celui de la microélectronique et plus particulièrement à la réalisation des dispositifs microélectroniques émetteurs de rayonnement lumineux. L'invention vise à réaliser un dispositif microélectronique émetteur de rayonnement lumineux dans lequel la dissipation thermique est améliorée.

### ART ANTÉRIEUR

Une puce LED (LED pour « light emitting diode ») comprend généralement au moins une zone de matériau semi-conducteur dopé selon un dopage de type p et au moins une zone de matériau semi-conducteur dopé selon un dopage de type n, les zones dopées formant une jonction, la zone active émettrice de lumière étant intercalée entre les deux zones dopées.

Il existe plusieurs configurations de puces LED, en fonction de la disposition de la jonction et des plots de contact électrique formés sur cette dernière.

Selon une première configuration dite « latérale », une puce LED peut être dotée de plots de contact disposés sur une zone semi-conductrice dopée p et de plots de contact sur une zone semi-conductrice dopée n, les zones dopées p et n étant situées côte à côte sur une même face d'un support. Ce support peut être un substrat de croissance, par exemple, à base de saphir, sur lequel les zones semi-conductrices dopées ont été formées.

Selon une configuration dite « verticale », les plots de contact sont disposés de part et d'autre d'une jonction comprenant une zone semi-conductrice dopée p et une zone semi-conductrice dopée n empilées.

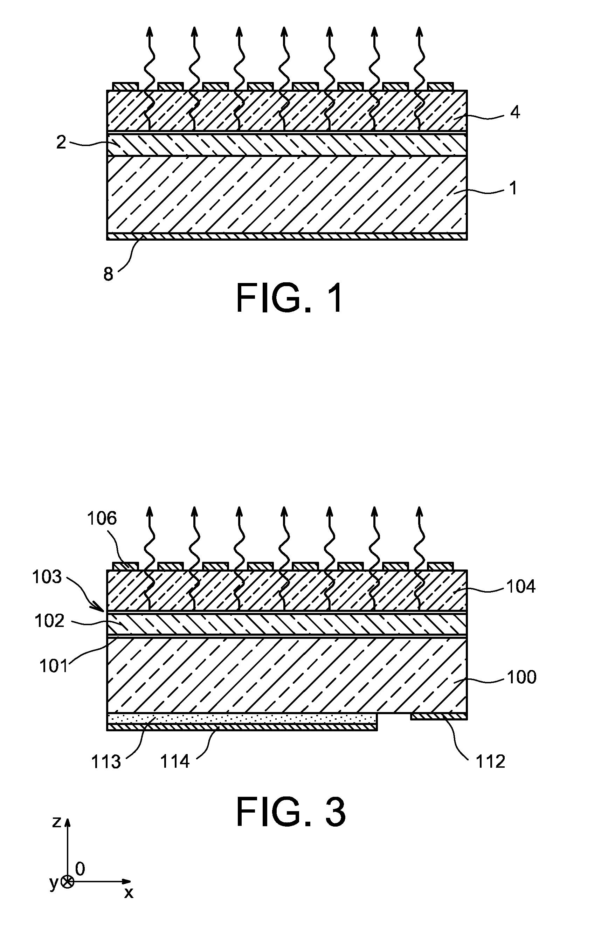

Un exemple de puce LED à configuration verticale est donné sur la figure 1.

Cette puce est formée d'un substrat conducteur 1, par exemple à base de Si dopé sur lequel repose une première couche semi-conductrice 2 dopée p elle-même recouverte par une deuxième couche semi-conductrice 4 dopée n. La zone active émettrice de lumière est intercalée entre les deux zones dopées 2 et 4. Par ailleurs, un empilement métallique (non représenté) est habituellement présent entre le substrat 1 et la couche 2 dopée p et assure des fonctions de conduction électrique et thermique et de réflexion optique. Pour permettre une connexion électrique, une ou plusieurs zones 6 de contact sont prévues sur la deuxième couche semi-conductrice 4 dopée n, tandis que sur une face du substrat conducteur 1 opposée à celle sur laquelle la première couche semi-conductrice 2 dopée p est formée, une autre zone de contact 8 est prévue.

La configuration verticale présente comme avantage de pouvoir réaliser la zone de contact 8, sur toute l'étendue de la couche semi-conductrice dopée p, ce qui permet de minimiser la résistance électrique et thermique de contact.

Dans une configuration verticale, on peut également avantageusement employer comme support de la jonction, un substrat différent de celui sur lequel cette jonction a été réalisée. Un substrat de report présentant une bonne résistance thermique peut être ainsi utilisé.

Le document US 2003/0015721 divulgue un exemple de composant comprenant une puce LED à configuration verticale.

Dans les composants LED, la dissipation thermique doit être optimisée afin d'éviter un sur-échauffement de la jonction.

Par exemple, lorsqu'un composant LED est intégré sur une carte mère, la puissance thermique générée par le composant intégré sur la carte mère est d'abord évacuée par conduction à travers le substrat de la puce, puis par un joint de report du substrat vers le support du composant, par exemple une embase métallique lorsque le support est un boîtier métallique. La chaleur peut être ensuite dissipée par conduction à travers un joint de report du boîtier métallique vers la carte mère puis à travers la carte mère, par un joint de report vers un système de dissipation thermique passif ou actif.

Dans une puce LED à configuration verticale telle que celle illustrée sur la figure 1, la zone de contact 8 constitue généralement une zone de dissipation thermique avec le support du composant sur lequel le substrat 1 est assemblé.

Cette zone de contact 8 est généralement assemblée avec un plot métallique 21 du support 20, lui-même isolé électriquement d'autres zones conductrices du support par l'intermédiaire d'une région d'isolation électrique du support.

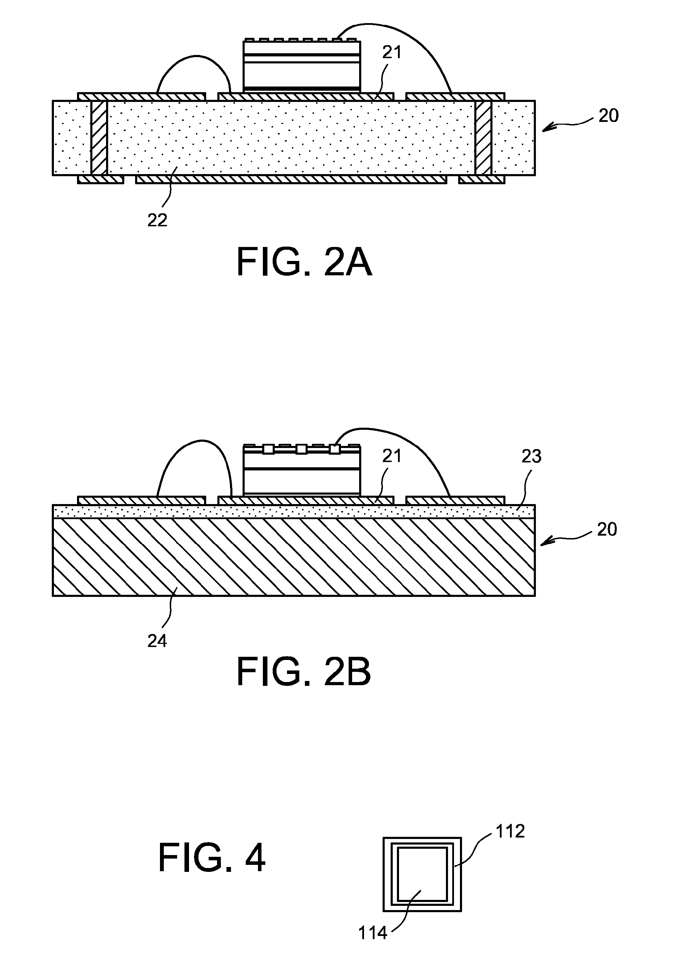

Un exemple d'intégration d'un composant LED suivant l'état de l'art sur un support 20 comprenant un boîtier céramique 22 est donné sur la figure 2A. Dans cet exemple le boîtier céramique forme la région d'isolation électrique du support. Un tel boîtier céramique a cependant de mauvaises propriétés de dissipation thermique.

Une alternative à l'intégration à un boîtier céramique est une intégration dans laquelle le support 20 est une carte. Pour cette technique illustrée sur la figure 2B et communément appelée « Chip On Board », la puce peut être rapportée sur un plot métallique 21 reposant sur une couche isolante 23, elle-même reposant sur un support métallique 24. Une couche isolante 23 d'épaisseur trop importante peut nuire à la dissipation thermique.

Le document CN202084524 divulgue un dispositif émetteur de rayonnement lumineux doté d'une jonction rapportée sur un support en cuivre doté de zones conductrices qui sont toutes connectées à la jonction et sont isolées électriquement entre elles par le biais d'un diélectrique recouvrant une partie du support.

Le document US2007/0246715A1 divulgue un dispositif émetteur de rayonnement lumineux doté d'une jonction rapportée sur un support, le support comportant des zones conductrices qui sont toutes connectées électriquement à la jonction et permettent une prise de contact électrique sur cette dernière. Afin d'améliorer la dissipation thermique, le support est prévu en aluminium et comporte une région permettant de dissiper la chaleur, cette région servant également de zone de prise de contact électrique.

Il se pose le problème d'améliorer davantage la dissipation thermique d'un dispositif microélectronique émetteur de rayonnement lumineux doté d'une configuration verticale.

### EXPOSÉ DE L'INVENTION

La présente invention concerne un dispositif émetteur de rayonnement lumineux comprenant : une jonction reposant sur un substrat conducteur doté d'une face donnée sur laquelle la jonction est formée, et d'une face opposée à ladite face donnée comprenant au moins une première zone conductrice dédiée à une prise de contact électrique et au moins une deuxième zone conductrice, isolée du substrat conducteur et de ladite première zone conductrice, la deuxième zone conductrice étant dédiée à une dissipation thermique.

Selon l'invention, le dispositif microélectronique émetteur de rayonnement lumineux comprend : une première zone semi-conductrice dopée et une deuxième zone semi-conductrice dopée disposée sur ladite première zone semi-conductrice dopée et formant avec ladite première zone semi-conductrice dopée une jonction, ladite jonction reposant sur un substrat conducteur, au moins une première région du substrat étant recouverte et en contact avec une première zone conductrice formant un contact électrique, au moins une deuxième région du substrat étant recouverte d'une deuxième zone conductrice disjointe de ladite première zone conductrice, ladite deuxième zone conductrice étant une zone de dissipation thermique, ladite deuxième région étant recouverte d'une zone d'isolation électrique intercalée entre ledit substrat et ladite deuxième zone conductrice.

Ainsi, suivant l'invention, on dédie au moins une première zone conductrice du dispositif à une conduction électrique et au moins une deuxième zone conductrice du dispositif à une dissipation thermique, la première conductrice et la deuxième zone conductrice étant électriquement isolées l'une de l'autre.

En dissociant les chemins de conduction électrique et de conduction thermique, un composant électroluminescent mis en oeuvre suivant l'invention permet d'avoir une dissipation thermique améliorée tout en assurant une connexion électrique aisée.

La deuxième zone conductrice de dissipation thermique est avantageusement prévue de manière à occuper sur le substrat une surface supérieure à celle occupée par ladite première zone conductrice.

Cela permet de favoriser la dissipation thermique.

Avantageusement, la deuxième zone conductrice n'est pas connectée électriquement à la jonction ou à un autre composant actif du dispositif.

Ainsi, la deuxième conductrice est dédiée uniquement à une dissipation thermique et ne sert pas de zone de contact électrique. La dissociation entre les chemins thermique et électrique est ainsi améliorée.

Selon une possibilité de mise en oeuvre du dispositif, la première zone semi-conductrice dopée de la jonction est disposée sur et en contact avec une première face du substrat conducteur, tandis que la première zone conductrice est disposée sur et en contact avec une deuxième face du substrat conducteur opposée à ladite première face, le dispositif étant doté en outre d'une ou plusieurs autres zones conductrices de contact disposées sur et en contact de la deuxième zone semi-conductrice dopée, lesdites autres zones conductrices de contact étant distinctes de ladite première zone conductrice et de ladite deuxième zone conductrice et n'étant électriquement connectées ni avec ladite première zone conductrice ni avec ladite deuxième zone conductrice.

La zone d'isolation électrique entre le substrat conducteur et la deuxième zone conductrice dédiée à la dissipation thermique peut présenter une résistance thermique inférieure ou égale à 5 K.mm²/W, de préférence à 1 K.mm²/W, et de préférence à 0,5 K.mm²/W.

L'épaisseur de ladite zone d'isolation électrique peut être comprise entre 0.05 µm et 20 µm, de préférence entre 0.1 µm et 1 µm.

Ladite zone d'isolation électrique peut être également à base d'un matériau présentant une conductivité thermique supérieure à 1 W/(m.K), et de préférence supérieure à 100 W/(m.K).

La zone d'isolation électrique peut être à base d'un matériau diélectrique.

Selon plusieurs possibilité de mise en oeuvre, ce matériau diélectrique peut être de l'oxyde de silicium, du nitrure de silicium ou un oxynitrure de silicium.

Selon une possibilité d'agencement du dispositif émetteur de rayonnement lumineux, ladite première région peut être une région périphérique d'une face du substrat et ladite deuxième région peut être une région centrale de ladite face du substrat, ladite première zone conductrice formant un contact électrique étant disposée autour de ladite deuxième zone conductrice de dissipation thermique.

Le dispositif peut comprendre en outre un support assemblé au substrat. Selon une possibilité de mise en oeuvre du dispositif dans laquelle la jonction repose sur une première face du substrat et dans laquelle la première zone conductrice et la deuxième zone conductrice sont disposées sur une deuxième face du substrat opposée à ladite première face, la première zone conductrice et la deuxième zone conductrice peuvent être assemblées avec un support.

Un premier plot conducteur du support peut être assemblé et connecté à ladite première zone conductrice formant un contact électrique. Ladite deuxième zone conductrice du substrat peut être assemblée à un deuxième plot. Par ailleurs, ladite deuxième zone semi-conductrice dopée peut être connectée à un troisième plot conducteur du support via le plot de contact. Le support doit alors comporter en outre des zones isolantes électriquement prévues respectivement entre ledit premier plot conducteur et ledit deuxième plot, et entre ledit deuxième plot et ledit troisième plot conducteur.

La présente invention concerne également un procédé de réalisation d'un dispositif microélectronique électroluminescent comprenant, dans cet ordre ou dans un ordre différent des étapes de :
- formation sur une première région d'une face donnée d'un substrat conducteur d'une première zone conductrice, et, sur une deuxième région de ladite face donnée, d'une deuxième zone conductrice, ladite deuxième zone conductrice reposant sur une zone d'isolation électrique et étant disjointe de ladite première zone conductrice,
- report sur une autre face du substrat opposée à la face donnée d'un empilement formé d'une première zone semi-conductrice dopée et d'une deuxième zone semi-conductrice dopée disposée sur ladite première zone semi-conductrice et formant avec cette dernière une jonction.

La deuxième zone conductrice de dissipation thermique est avantageusement réalisée de manière à occuper sur le substrat une surface supérieure à celle occupée par ladite première zone conductrice.

Avantageusement, la deuxième conductrice est réalisée de manière à ne pas être connectée électriquement à la jonction ou à un autre composant actif du dispositif.

Le procédé peut comprendre en outre une étape d'assemblage de la première face du substrat avec un support, la première zone conductrice étant assemblée avec un premier plot conducteur dudit support, la deuxième zone conductrice étant assemblée avec un deuxième plot dudit support, ledit premier plot conducteur et ledit deuxième plot étant séparés par au moins une zone isolante.

Le procédé peut comprendre en outre une étape de connexion, en particulier par câblage avec au moins un fil conducteur, entre un troisième plot conducteur dudit support et ladite deuxième zone semi-conductrice dopée, ledit deuxième plot et ledit troisième plot conducteur étant séparés par une zone isolante.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
la figure 1 illustre un exemple de puce émettrice de rayonnement lumineux, mis en oeuvre suivant l'art antérieur ;
les figures 2A-2B illustrent des exemples d'assemblage de la puce de la figure 1 avec différents support ;
la figure 3 illustre un exemple de puce émettrice de rayonnement lumineux, mis en oeuvre suivant l'invention, dotée de moyens de connexion électrique et de moyens de dissipation thermique dissociés et formés sur une même face d'un substrat ;
la figure 4 illustre un exemple d'agencement particulier de moyens de connexion électrique et de moyens de dissipation thermique dissociés et formés sur une même face d'un substrat de puce émettrice de rayonnement lumineux telle que mis en oeuvre suivant l'invention ;
la figure 5 illustre un exemple de dispositif émetteur de rayonnement lumineux, comprenant une puce émettrice de rayonnement lumineux telle que mis en oeuvre suivant l'invention assemblée à un support sous forme d'un boîtier métallique ;
la figure 6 illustre un exemple de dispositif émetteur de rayonnement lumineux, comprenant une puce émettrice de rayonnement lumineux assemblée à un support sous forme d'une carte ;
les figures 7A-7H illustrent un exemple de procédé de réalisation d'un dispositif microélectronique émetteur de rayonnement lumineux mis en oeuvre suivant l'invention ;
la figure 8 illustre un exemple d'assemblage entre une puce émettrice de rayonnement lumineux tel que mis en oeuvre suivant l'invention et un support.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de dispositif électroluminescent tel que mis en oeuvre suivant l'invention, est donné sur la figure 3. Ce dispositif comporte une puce LED en configuration verticale.

Ce dispositif est formé sur un substrat 100 conducteur et par exemple à base d'un métal tel que du Cu ou du Ni, ou d'un semi-conducteur dopé, par exemple à base de Si ou de Ge ou de diamant ou de SiC ou d'AIN.

Selon une autre possibilité, le substrat 100 peut être prévu à base d'un matériau composite à base de plusieurs métaux, par exemple à base de Cu et de W, ou de Cu et de Mo, ou en variante de métal et de semi-conducteur, , par exemple à base d'AI et de Si, ou d'AI et de SiC.

Le matériau du substrat peut être choisi de manière à présenter une conductivité thermique d'au-moins 1 W/(m.K), de préférence supérieure à 100 W/(m.K).

Une première face du substrat 100 est recouverte d'une couche ou d'un empilement métallique 101 assurant un contact électrique et ayant une fonction de réflecteur optique. Cette couche ou cet empilement métallique 101 est surmonté(e) et en contact d'une couche semi-conductrice 102, par exemple à base de GaN, dopée selon un dopage d'un premier type, par exemple dopée p.

L'empilement métallique 101 assure ainsi une connexion électrique entre la première face du substrat 100 et la couche semi-conductrice 102.

Cette couche semi-conductrice 102 est elle-même recouverte d'une autre couche semi-conductrice 104, par exemple à base de GaN, dopée selon un dopage d'un deuxième type, par exemple dopée n, les couches 102 et 104 formant une jonction. La zone active 103 émettrice de lumière est intercalée entre les deux couches semi-conductrices 102 et 104.

Les couches semi-conductrices 102 et 104 sont réparties de telle sorte que la jonction s'étend sur toute la surface de la première face du substrat 100. Dans l'exemple de réalisation de la figure 3, la surface sur laquelle s'étend la jonction mesurée dans un plan parallèle à celui de la première face du substrat 100, est sensiblement égale à la surface de cette première face du substrat 100.

La couche semi-conductrice 104 dopée n peut être recouverte d'une ou plusieurs zones 106 de contact électrique. Ces zones 106 de contact peuvent être métalliques et par exemple à base d'un matériau adapté pour réaliser une prise de contact sur un semi-conducteur de type n, par exemple un empilement métallique à base de Ti/Al/Ni/Au.

Une deuxième face du substrat 100, opposée à la première face, comporte quant à elle, dans une première région, une première zone conductrice 112 en contact avec le matériau conducteur du substrat 100. Cette première zone conductrice 112 est destinée à former un contact électrique sur la première face du substrat 100 et peut être par exemple à base d'un matériau métallique tel qu'un empilement de Ti/Au dans le cas d'un substrat semi-conducteur.

La première zone conductrice 112 est ainsi connectée électriquement à la couche semi-conductrice 102 de la jonction tandis que les zones 106 de contact sont connectées électriquement à la couche semi-conductrice 104 de la jonction.

Dans une deuxième région de sa deuxième face, le substrat 100 comporte une deuxième zone conductrice 114, disjointe de la première zone conductrice, et destinée quant à elle, à former une zone de dissipation thermique. La deuxième zone conductrice 114 s'étend au moins en partie en regard de la jonction, mais n'est pas connectée électriquement à la jonction ou à un autre composant actif du dispositif. La deuxième zone conductrice 114 peut être par exemple à base d'un matériau métallique tel qu'un empilement de Ti/Au dans le cas d'un substrat semi-conducteur. La deuxième zone conductrice 114 n'est pas en contact avec le matériau conducteur du substrat 100.

La deuxième zone conductrice 114 est isolée électriquement de ce dernier par l'intermédiaire d'une zone 113 d'isolation électrique.

La deuxième zone conductrice 114 peut être ainsi totalement séparée du substrat 100 par le biais du matériau diélectrique de la zone 113. Ainsi, la deuxième zone conductrice 114 peut jouer un rôle de zone de dissipation de chaleur sans pour autant servir de zone de prise de contact électrique sur la puce ou un composant.

La deuxième zone conductrice 114 formant une zone de dissipation de chaleur est distincte des zones 106 de contact et de la première zone semi-conductrice 112, et n'est électriquement connectée ni aux zones 106 de contact ni à la première zone semi-conductrice 112.

La zone 113 d'isolation électrique peut être à base d'un matériau semi-conducteur non dopé, par exemple à base d'AIN non dopé ou de Si polycristallin non dopé ou de diamant non dopé. La zone 113 peut être avantageusement à base d'un matériau diélectrique tel que de l'oxyde de silicium, du nitrure de silicium ou de l'oxynitrure de silicium, choisi de manière à présenter une faible résistance thermique, en particulier une résistance thermique d'au plus 5 K.mm²/W. La résistance thermique de la zone 113 est de préférence inférieure ou égale à 1 K.mm²/W, et de préférence inférieure ou égale à 0,5 K.mm²/W. La résistance thermique est définie comme le rapport entre l'épaisseur de la zone 113 sur la conductivité thermique de celle-ci.

Tout en respectant ce critère de résistance thermique, l'épaisseur de ladite zone d'isolation électrique peut être comprise entre 0.05 µm et 20 µm, de préférence entre 0.1 µm et 1 µm. Par ailleurs, le matériau de la zone 113 peut présenter une conductivité thermique supérieure à 1 W/(m.K), et de préférence supérieure à 100 W/(m.K).

On obtient ainsi un dispositif électroluminescent dont les chemins électriques et les chemins de dissipation thermique sont dissociés au maximum.

Afin d'améliorer la dissipation thermique, la deuxième zone conductrice 114 de dissipation thermique peut être prévue de manière à occuper une surface sur le substrat 100 supérieure à la surface occupée par la première zone conductrice 112 établissant un contact électrique. La surface occupée par la deuxième zone conductrice 114 de dissipation thermique sur le substrat 100 peut être avantageusement prévue au moins 50 % supérieure à celle occupée par la première zone conductrice 112 sur le substrat 100 et de préférence 80 % supérieure à celle occupée par la première zone conductrice 112.

Selon un exemple de réalisation particulier du dispositif (la puce étant représentée selon une vue de dessous sur la figure 4), la deuxième zone conductrice 114 est disposée en périphérie de la deuxième face du substrat 100 et entoure la première zone conductrice 112 située quant à elle au centre de la deuxième face du substrat 100, la première zone conductrice 112 et la deuxième zone conductrice 114 étant distinctes, c'est-à-dire n'étant pas connectées l'une à l'autre.

La puce qui vient d'être décrite peut être disposée seule sur un support.

Cependant, plusieurs puces peuvent également être disposées sur un tel support, interconnectées électriquement en série et /ou parallèle.

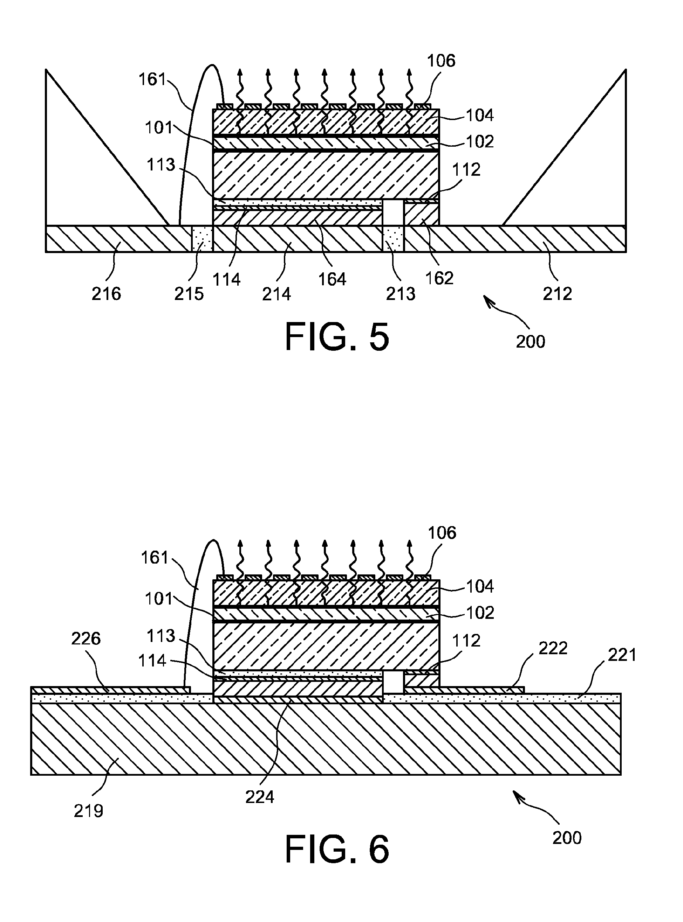

Le substrat 100 peut être ainsi assemblé ou reporté sur un support. Différents exemples de supports sur lequel la puce qui vient d'être décrite peut être reportée, sont donnés sur les figures 5 et 6.

La figure 5 illustre un exemple d'assemblage d'une puce émettrice de rayonnement lumineux précédemment décrite avec un support 200 sous forme d'un boîtier métallique. Le support 200 peut être doté de plots métalliques 212, 214, 216 disjoints et isolés entre eux par l'intermédiaire de zones diélectriques 213 et 215.

Un plot métallique 212 du support 200 est connecté et assemblé à la première zone conductrice 112 de la puce, par exemple par l'intermédiaire d'un matériau métallique formant un joint 162 de soudure.

Un autre plot métallique 214 du support 200 est connecté et assemblé à la deuxième zone conductrice 114 de la puce, par exemple par l'intermédiaire d'un matériau métallique formant un autre joint 164 de soudure.

Ainsi, le plot métallique 212 permet une prise de contact électrique sur la puce, tandis que l'autre plot métallique 214 permet de jouer le rôle de dissipation thermique, les deux plots 212 et 214 étant isolés entre eux électriquement par l'intermédiaire de la zone diélectrique 213 les séparant.

Le support 200 comporte en outre un autre plot métallique 216 qui est connecté à la deuxième zone semi-conductrice dopée 104 de la puce. La connexion peut être établie à l'aide d'un fil métallique 161 et avoir été réalisée par un procédé communément appelé de « wire bonding » encore appelé câblage par fil.

Le plot métallique 216 est isolé électriquement du plot métallique 214 du support 200 par l'intermédiaire de la zone diélectrique 215.

La figure 6 illustre un autre exemple d'assemblage de la puce précédemment décrite avec un support 202 qui peut être sous forme d'une carte, par exemple une carte de circuit imprimé de type MCPCB (MCPCB pour « Metal Core Printed Circuit Board »). Le support 202 peut être, dans cet exemple, formé d'une couche métallique 219, recouverte d'une couche isolante 221 qui peut être à base d'un matériau diélectrique tel que du FR4 (matériau standard pour les circuits imprimés constitué de fibres de verre dans une matrice époxy), d'un polymère chargé de particules minérales permettant d'augmenter la conductivité thermique ou encore d'une céramique inorganique obtenue soit par dépôt, soit par oxydation anodique de l'aluminium si la couche métallique 219 est de l'aluminium.

Dans cet exemple, le support 200 est doté de plots conducteurs 222, 226 qui reposent sur, et sont en contact avec, la couche isolante 221. Les plots conducteurs 222, 226 et l'élément métallique 219 sont ainsi isolés électriquement les uns vis-à-vis des autres. Les plots conducteurs 222, 226 du support 200 sont prévus pour établir une prise de contact électrique respectivement avec la première zone conductrice 112 disposée sur la première face du substrat 100 et avec une zone de contact 106 disposée sur la deuxième face du substrat 100.

Un plot conducteur 224 est quant à lui en contact avec l'élément métallique 219 du support 200 et avec la deuxième zone conductrice 114 du substrat 200.

Le plot conducteur 224, est prévu pour réaliser une dissipation thermique et peut être prévu à base d'un matériau présentant une conductivité thermique élevée, par exemple un métal tel qu'une couche d'accrochage définie par la suite et un empilement comprenant au-moins un des métaux parmi cuivre, nickel, argent et or.

Ce plot 224 est isolé des autres plots conducteurs 222, 226 par l'intermédiaire de la couche isolante 221, de sorte que les chemins de dissipation thermique et de conduction électrique sont également dissociés au niveau du support 200.

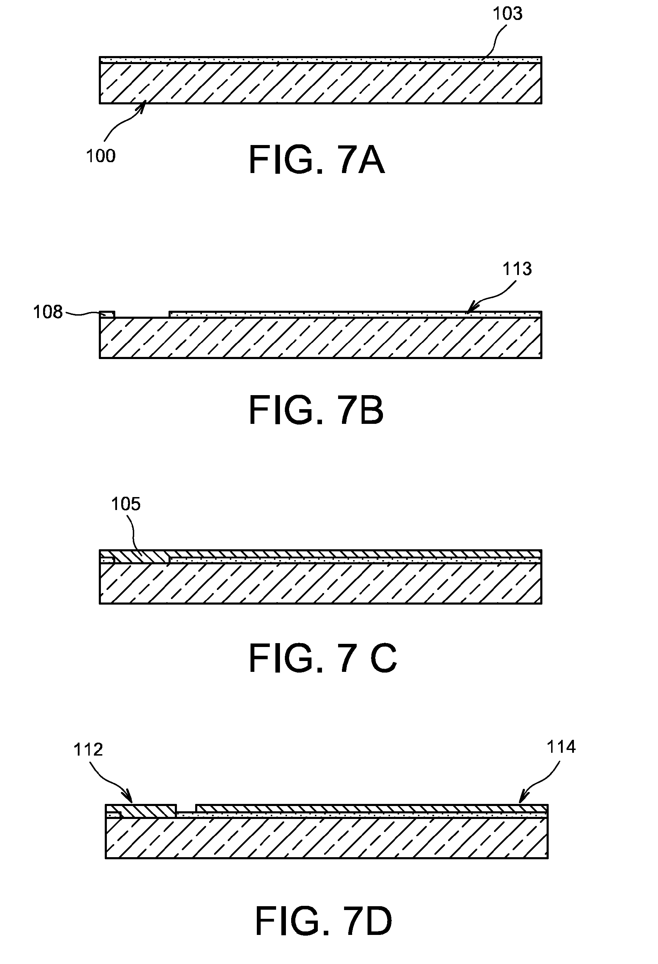

Un exemple de procédé de réalisation d'un dispositif microélectronique électroluminescent suivant l'invention, du type de celui décrit précédemment, va à présent être donné en liaison avec les figures 7A-7H.

Le matériau de départ du procédé peut être un substrat 100 conducteur, à base de métal tel que, par exemple, du Cu ou du Ni, ou à base de semi-conducteur dopé tel que, par exemple, du Si dopé ou du Ge dopé ou du diamant dopé ou du SiC dopé ou de l'AIN dopé, ou à base d'un matériau métallique composite formé par exemple, de Cu et de W, ou de Cu et de Mo, ou à base d'un matériau composite formé de métal et de semi-conducteur, tel que, par exemple, de l'AI et du Si, ou de l'AI et du SiC. Le substrat 100 peut avoir une épaisseur comprise par exemple entre 5 µm et 2000 µm.

Sur le substrat 100, on forme tout d'abord (figure 7A) une couche 103 qui n'est pas électriquement conductrice et peut être à base d'un matériau semi-conducteur et non dopé, ou de préférence à base d'un matériau diélectrique tel que d'oxyde de silicium, de nitrure de silicium voire d'oxynitrure de silicium. Le matériau de la couche 103 peut être choisi, outre le fait de permettre une isolation électrique, de manière à avoir également une faible résistance thermique, c'est-à-dire une résistance d'au plus 5K.mm²/W. La couche isolante 103 peut avoir une épaisseur comprise par exemple entre 50 nanomètres et 20 micromètres.

On peut ensuite graver la couche 103 du substrat 100 dans une première région d'une face de ce dernier, de manière à dévoiler localement cette face pour une reprise de contact sur le substrat 100. La portion restante de la couche 103 forme une zone d'isolation électrique 113 dans une deuxième région de ladite face du substrat 100 (figure 7B). Un plot 108 isolant électrique demeure en bordure du substrat, dans la première région, dans le but de passiver les flancs.

Puis, on forme une couche conductrice 105 d'épaisseur comprise par exemple entre 0,01 et 10 µm sur la couche isolante 103 et la première région. La couche conductrice 105 peut comprendre une couche de matériau métallique d'accrochage tel que du Ti, du TiN, du Cr, du W, du TiN, du WN et un empilement comprenant au-moins un des métaux parmi cuivre, argent, nickel et or. (Figure 7C).

Une portion de la couche conductrice 105 est ensuite gravée dans une zone située entre ladite première région et entre ladite deuxième région, de manière à former une première zone conductrice 112 en contact avec le substrat 100 et une deuxième zone conductrice 114 reposant sur, et en contact avec, la zone isolante 113, la première zone conductrice 112 étant disjointe de la deuxième zone conductrice 114 (figure 7D).

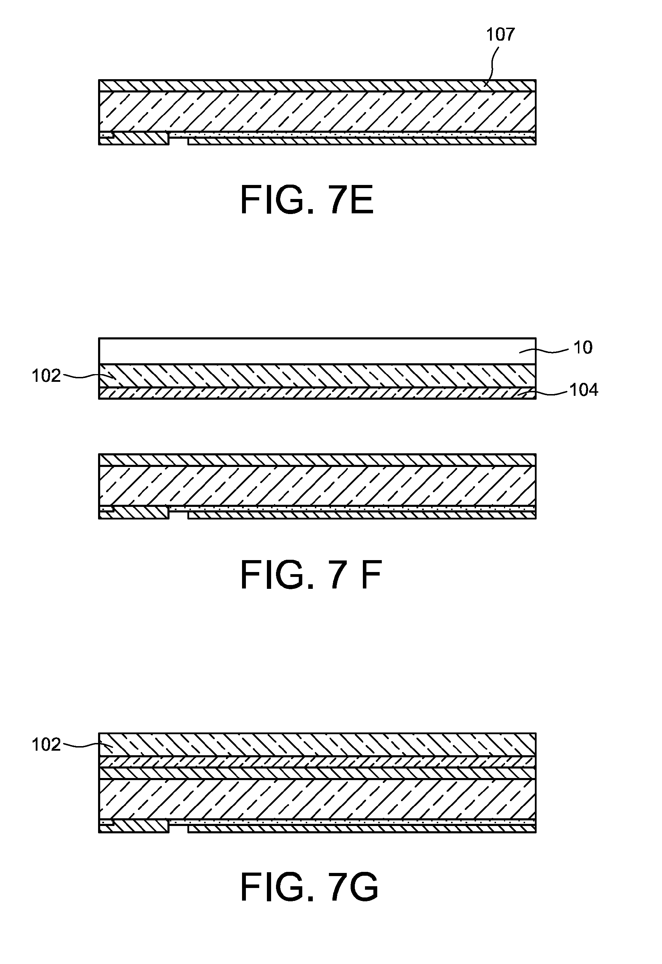

Ensuite, sur l'autre face du substrat 100, opposée à celle sur laquelle les zones conductrices 112, 114 ont été réalisées, on forme une couche d'accrochage 107. Cette couche d'accrochage 107 peut être par exemple à base d'un matériau métallique tel que tel que du Ti, du TiN, du Cr, du W, du TiN, du WN et un empilement comprenant au-moins un des métaux parmi cuivre, argent, nickel et or. (Figure 7E).

On peut ensuite former une jonction, en particulier une jonction en configuration verticale d'une diode électroluminescente sur le substrat 100.

Pour cela, on peut effectuer un report sur la couche 107 d'accrochage, d'un empilement de couches 10, 104, 102 comportant une couche semi-conductrice dopée 104, par exemple selon un dopage de type p, recouverte et en contact avec une autre couche dopée 102, par exemple selon un dopage de type n. Les couches semi-conductrices 102, 104 dopées peuvent avoir été réalisées par croissance sur un substrat 10 de croissance, par exemple à base de saphir (figure 7F).

L'empilement peut également comprendre, entre la couche semi-conductrice 104 dopée p et la couche semi-conductrice 102 dopée n, la zone active émettrice de lumière étant intercalée entre les deux zones dopées. L'empilement peut également comprendre une ou plusieurs couches métalliques 101 destinée à former un réflecteur optique et à assurer des fonctions de conduction électrique et thermique.

Le report peut être réalisé, selon une possibilité, par brasage, par exemple d'Au et de Sn, ou d'Au et de Si, ou d'Au et d'In, ou d'Au et de Ge, ou de Pd et d'Ag, ou de Pd et d'In.

Selon une autre possibilité de mise en oeuvre, le report peut être réalisé par collage par adhésion moléculaire, par exemple entre deux zones de cuivre ou encore avec des matériaux comportant des nano-particules d'Ag ou d'Au frittables à basse température.

Pour permettre cet assemblage, une refusion d'alliage de brasure ou une thermo-compression peut être mise en oeuvre.

Après report sur la couche d'accrochage 107 de l'empilement comprenant la jonction, le substrat 10 de croissance peut être détaché (figure 7G).

Le détachement peut être par exemple réalisé par un procédé utilisant un laser connu sous le nom de lift-off laser (LLO) en particulier dans le cas où le substrat 10 est à base de saphir, ou par amincissement réalisé par action mécanique et/ou chimique, dans le cas, par exemple où le substrat 10 de croissance est à base de Si.

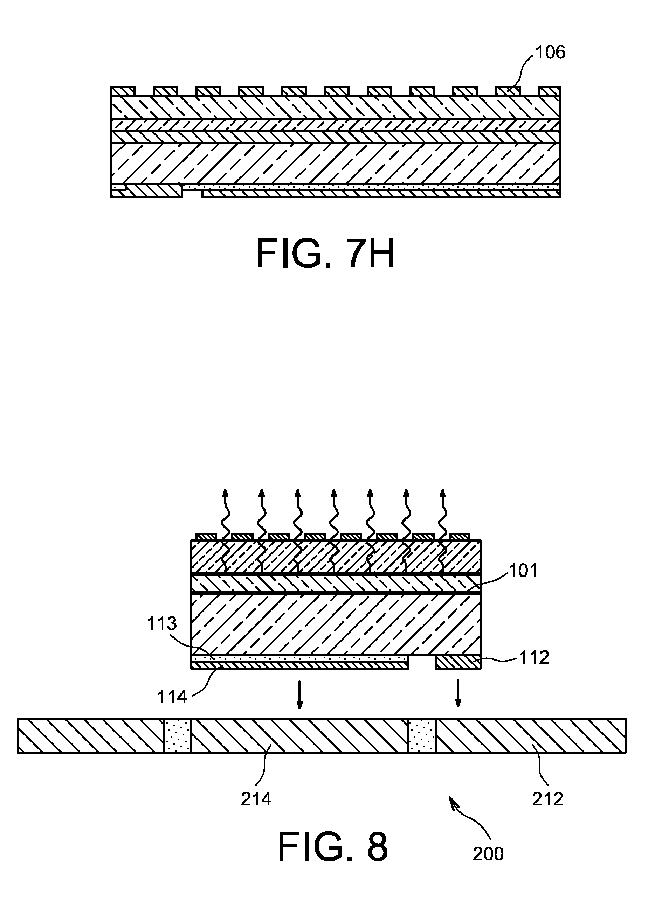

Ensuite (figure 7H), on forme une ou plusieurs zones 106 de contact sur la couche semi-conductrice 104, par exemple par dépôt d'un matériau métallique tel que par exemple un empilement à base de Ti, Al, Ni et Au, puis gravure de ce matériau à l'aide de KOH pour en texturer la surface et ainsi améliorer l'extraction de lumière.

Une passivation isolante des bords de puce peut être réalisée préalablement ou postérieurement à l'étape qui vient d'être décrite.

Selon une possibilité, le dispositif dont la réalisation vient d'être décrite, peut être ensuite découpé en plusieurs puces ou en plusieurs composants.

Le dispositif dont la réalisation vient d'être décrite peut être également assemblé, avec un support, tel qu'un boîtier de composant ou une carte destinée à accueillir une pluralité de composants.

Une étape d'assemblage entre le substrat 100 et un support 200 de type boîtier métallique est illustré par exemple sur la figure 5.

Pour réaliser cet assemblage, un apport de matériau métallique peut être réalisé sur des plots 212, 214 du support. Dans l'exemple illustré sur la figure 8, l'assemblage est réalisé sans apport de matière afin de diminuer la résistance thermique et électrique des contacts.

Selon une mise en oeuvre particulière du procédé, le matériau conducteur du substrat 100 initial peut être un matériau semi-conducteur dopé à base de Si ou de Ge d'épaisseur importante.

Dans ce cas et pour réduire la résistance thermique, une étape d'amincissement du substrat 100 peut être éventuellement mise en oeuvre, par exemple après la formation des zones conductrices 112, 114 sur la face opposée décrite en liaison avec les figures 7D et 7E, et avant la formation de la couche d'accrochage décrite précédemment en liaison avec la figure 7E.

Dans ce cas, l'amincissement peut être effectué par polissage chimique et/ou mécanique. Pour cela, le substrat 100 peut être fixé sur un substrat temporaire servant de substrat poignée. Ceci peut être réalisé au moyen d'un adhésif temporaire sur la face du substrat comportant les zones conductrices 112, 114.

Selon une autre variante de mise en oeuvre du procédé, on peut effectuer l'assemblage décrit précédemment en liaison avec la figure 7F et l'étape d'amincissement, préalablement aux étapes de réalisation des zones conductrices 112 et 114.

L'enchainement des étapes est alors : formation de la couche 103 isolante électriquement (fig.7A) ; gravure de la couche 103 pour former la zone 113 (fig.7B) ; formation de la couche d'accrochage 107 (fig.7E) ; assemblage (fig.7F), amincissement, dépôt de la couche conductrice 105 (fig.7C), gravure de la couche 105 (fig.7D). L'assemblage est ensuite fixé sur un substrat poignée temporaire préalablement au retrait du substrat de croissance 10 (étape 7G).

Le procédé de réalisation de la LED aboutissant à la structure illustrée sur la figure 7H est poursuivi, et dans le cas d'un substrat poignée, celui-ci pourra être retiré par exemple avant découpe et/ ou assemblage des puces élémentaires sur support boîtier ou carte.

## Revendications

1. Dispositif microélectronique émetteur de rayonnement lumineux comprenant : une première zone semi-conductrice dopée (102) et une deuxième zone semi-conductrice dopée (104) disposée sur ladite première zone semi-conductrice dopée et formant avec ladite première zone semi-conductrice dopée une jonction, ladite jonction reposant sur un substrat conducteur (100), au moins une première région du substrat étant recouverte et en contact avec une première zone conductrice (112) formant un contact électrique, au moins une deuxième région du substrat étant recouverte d'une deuxième zone conductrice (114) disjointe de ladite première zone conductrice, ladite deuxième zone conductrice (114) étant une zone de dissipation thermique, ladite deuxième région étant recouverte d'une zone d'isolation électrique (113) intercalée entre ledit substrat (100) et ladite deuxième zone conductrice (114), ladite deuxième zone conductrice (114) de dissipation thermique occupant sur le substrat (100) une surface supérieure à celle occupée par ladite première zone conductrice (112).

2. Dispositif microélectronique selon la revendication 1, ladite deuxième zone conductrice (114) n'étant pas connectée électriquement à ladite jonction.

3. Dispositif microélectronique selon l'une des revendications 1 ou 2, dans lequel la première zone semi-conductrice dopée (102) de la jonction est disposée sur et en contact avec une première face du substrat conducteur (100) et dans lequel la première zone conductrice (112) est disposée sur et en contact avec une deuxième face du substrat conducteur (100) opposée à ladite première face,
le dispositif étant doté en outre d'une ou plusieurs zones de contact (106) disposées sur et en contact de la deuxième zone semi-conductrice dopée (104), lesdites zones de contact (106) n'étant électriquement connectées ni avec ladite première zone conductrice (112) ni avec ladite deuxième zone conductrice (114).

4. Dispositif microélectronique selon l'une des revendications 1 à 3, dans lequel ladite première région est une région périphérique d'une face du substrat (100) et dans lequel ladite deuxième région est une région centrale de ladite face du substrat, ladite première zone conductrice (112) formant un contact électrique étant disposée au moins en partie autour de ladite deuxième zone conductrice (114) de dissipation thermique.

5. Dispositif microélectronique selon l'une des revendications 1 à 4, ladite zone d'isolation électrique (113) présente une résistance thermique inférieure ou égale à 5K.mm²/W.

6. Dispositif microélectronique selon la revendication 5, ladite zone d'isolation électrique (113) ayant une épaisseur comprise entre 0,05 µm et 20 µm.

7. Dispositif microélectronique selon l'une des revendications 5 ou 6, ladite zone d'isolation électrique (113) étant à base d'un matériau présentant une conductivité thermique supérieure à 1W/(m.K).

8. Dispositif microélectronique selon la revendication 7, ladite zone d'isolation électrique (113) étant à base d'un matériau diélectrique tel que de l'oxyde de silicium, de nitrure de silicium ou d'oxynitrure de silicium.

9. Dispositif microélectronique selon l'une des revendications 1 à 8, dans lequel la jonction repose sur une première face du substrat et dans lequel la première zone conductrice (112) et la deuxième zone conductrice (114) sont disposées sur une deuxième face du substrat opposée à ladite première face, la première zone conductrice (112) et la deuxième zone conductrice (114) étant assemblées avec un support (200, 202).

10. Dispositif microélectronique selon la revendication 9, dans lequel un premier plot conducteur (212, 222) dudit support est assemblé et connecté à ladite première zone conductrice (112), ladite deuxième zone conductrice (114) du substrat étant assemblée à un deuxième plot (214, 224), ladite deuxième zone semi-conductrice dopée (104) étant connectée à un troisième plot conducteur (216, 226) du substrat, le support comportant en outre des zones isolantes (213, 215, 221) prévues respectivement entre ledit premier plot conducteur (212, 222) et ledit deuxième plot (214, 224), et entre ledit deuxième plot (214, 224) et ledit troisième plot conducteur (216, 226).

11. Système microélectronique comportant une pluralité de dispositifs microélectroniques selon la revendication 9 ou 10, lesdits dispositifs étant assemblés sur le même support (200, 202), et interconnectés les uns aux autres en série ou en parallèle.

12. Procédé de réalisation d'un dispositif microélectronique électroluminescent comprenant, des étapes de :
- formation sur une première région d'une face donnée d'un substrat conducteur (100) d'une première zone conductrice (112) et, sur une deuxième région de ladite face donnée, d'une deuxième zone conductrice (114), ladite deuxième zone conductrice (114) reposant sur une zone d'isolation électrique (113) et étant disjointe de ladite première zone conductrice, ladite deuxième zone conductrice (114) de dissipation thermique occupant sur ladite face donnée du substrat (100) une surface supérieure à celle occupée par ladite première zone conductrice (112),
- report sur une autre face du substrat opposée à ladite face donnée d'un empilement formé d'une première zone semi-conductrice dopée (102) et d'une deuxième zone semi-conductrice dopée (104) disposée sur ladite première zone semi-conductrice (102) et formant avec cette dernière une jonction.

13. Procédé de réalisation d'un dispositif microélectronique électroluminescent selon la revendication 12, comprenant en outre une étape d'assemblage de la face donnée dudit substrat conducteur (100) avec un support (200, 202), la première zone conductrice (112) étant assemblée avec un premier plot conducteur (212, 222) dudit support, la deuxième zone conductrice (114) étant assemblée avec un deuxième plot (214, 224) dudit support, ledit premier plot conducteur et ledit deuxième plot conducteur étant séparés par au moins une zone isolante (213, 221).

14. Procédé de réalisation d'un dispositif microélectronique électroluminescent selon la revendication 13, comprenant en outre une étape de connexion, entre un troisième plot conducteur (216, 226) dudit support (200, 202) et ladite deuxième zone semi-conductrice dopée (104), ledit troisième plot conducteur (216, 226) et ledit deuxième plot (214, 224) étant séparés par une zone isolante (215, 221).

15. Procédé de réalisation collective d'une pluralité de dispositifs microélectroniques électroluminescents selon l'une quelconque des revendications 1 à 10, **caractérisé en ce qu'**on effectue les étapes du procédé selon les revendications 12 à 14 sur le même substrat conducteur (100).
